# EUROPÄISCHE PATENTANMELDUNG

(11) **EP 2 259 078 A2**
(43) Veröffentlichungstag der Anmeldung: **08.12.2010**
(21) Anmeldenummer: 10011605.2
(22) Anmeldetag: 16.12.2003
(51) Int. Cl.: G01R 11/04

(54) **Vorrichtung zur Ankopplung eines Stromzählers an eine Trägerplattform**

(30) Priorität: 20.12.2002 DE 10261206; 16.05.2003 DE 10323160
(62) Teilanmeldung aus: 03028854.2
(71) Anmelder: Hager Electro GmbH & Co. KG, 66440 Blieskastel (DE)
(72) Erfinder: Die Erfindernennung liegt noch nicht vor
(74) Vertreter: Bernhardt, Winfrid

(57) **Zusammenfassung**

Die Erfindung betrifft eine Vorrichtung zur Ankopplung eines Stromzählers an eine Trägerplattform. Gemäß der Erfindung ist ein an der Trögerplattform anbringbarer Adapter vorgesehen, an welchen der Stromzähler unter Verbindung mit Stromleitern, insbesondere ohne Werkzeug durch eine Schnellkupplung, mechanisch koppelbar ist, wobei der Adapter auf einer der Trögerplattform zugewandten Seite Hakenelemente (106-108) zur Verbindung des Adapters mit der Trägerplattform aufweist.

## Beschreibung

Die Erfindung betrifft eine Vorrichtung zur Ankopplung eines Stromzählers an eine Trägerplattform.

Zum Beispiel in Wohnhäusern installierte Stromzähler sind in einem Zählerkasten untergebracht, an dessen die Trägerplattform bildenden Boden der Stromzähler mechanisch befestigt ist und in welchen die an den Zähler anzuschließenden Stromleitungen hineingeführt sind. Bekanntermaßen erfolgt die Befestigung des Stromzählers mit Hilfe des sogenannten Zählerkreuzes, das durch einen vertikalen und horizontalen Befestigungsschenkel gebildet ist, wobei die Befestigungsschenkel am Boden des Zählerkastens angebracht sind.

In zunehmendem Maße werden die herkömmlichen elektromechanischen Stromzähler durch elektronische Zähler ersetzt. Parallel dazu strebt man an, die Installation und Auswechslung von Stromzählern an den Zählerplätzen zu vereinfachen.

Die DE 100 52 998 A1 beschreibt eine zur Aufnahme eines elektronischen Zählers vorgesehene Trägerplattform, an welcher der Stromzähler ohne Verwendung eines Werkzeugs über eine Schnellkupplung ankoppelbar ist, wobei mit der Ankopplung automatisch eine Verbindung mit zum Zähler führenden und vom Zähler wegführenden Stromleitungen erfolgt. Der Stromzähler weist auf seiner der Trägerplattform zugewandten Seite vorstehende Kontaktstifte auf, welche in Öffnungen in der Trägerplattform eingreifen und in Kontakt mit in der Trägerplattform vorgesehenen Federkontaktelementen kommen. Durch Verschiebung auf der Plattform lässt sich der Stromzähler in eine Verriegelungsposition bringen, in welcher er durch Formschluss mechanisch mit der Plattform verbunden ist.

Der Erfindung liegt die Aufgabe zugrunde, die Einführung neuer, technisch verbesserter Stromzähler zu beschleunigen.

Diese Aufgabe wird durch einen an der Trägerplattform anbringbaren Adapter gelöst, an welchem der Stromzähler unter Verbindung mit Stromleitern koppelbar ist.

Vorteilhaft lassen sich durch diese Erfindungslösung herkömmliche, z.B. das Zählerkreuz verwendende Trägerplattformen in Verbindung mit neuen, in anderer Weise an eine Trägerplattform zu koppelnden Stromzählern weiternutzen.

Zweckmäßig lässt sich der Stromzähler an dem Adapter unter automatischer Verbindung mit den Stromleitern ohne Werkzeugeinsatz über eine Schnellkopplung, vorzugsweise durch Formschluss, befestigen.

In der bevorzugten Ausführungsform der Erfindung weist der Adapter einen einseitig offenen Kasten mit einem den Stromzähler aufnehmenden Zwischenboden auf.

Sämtliche Stromleiter sind zu einer an einer Seite des Kastens angeordneten Anschlussleiste geführt.

Die Stromleiter weisen z.B. Federkontaktelemente mit einer gegen einen Überbrückungsleiter anliegenden Kontaktnase auf, wobei die Kontaktnase durch ein vom Gehäuse des Stromzählers vorstehendes Kontaktelement bei der Ankopplung des Stromzählers an den Adapter von dem Überbrückungsleiter trennbar ist. Im nicht gekoppelten Zustand ist der zum Zähler führende Leiter und mit dem vom Zähler wegführende Stromleiter durch den Überbrückungsleiter kurzgeschlossen.

Vorteilhaft ist in einer ersten Kopptungsphose, während die vom Zählergehäuse vorstehenden Kontakte schon elektrisch mit den Federkontaktelementen verbunden sind, die Überbrückung noch nicht aufgehoben. In dieser Phase kann die Funktion des Zählers überprüft werden, bevor er in die Endstellung gebracht wird, in welcher die Kontaktnasen vom Überbrückungsleiter getrennt sind. So lässt sich z.B. verhindern, dass durch Ankopplung eines defekten Zählers der Stromfluss unterbrochen wird.

In weiterer Ausgestaltung der Erfindung können an dem Adapter Einrichtungen zur Anbringung weiterer Geräte angebracht sein, z.B. mit dem Stromzähler verbundene Steuergeräte, die zeitabhängig den Stromtarif ändern. So lässt z.B. der den Stromzähler aufnehmende Zwischenboden über die vom Stromzähler eingenommenen Fläche hinaus erweitern und sich über dem erweiterten Zwischenboden eine Hutschiene anordnen.

In einer weiteren Ausführungsform, die in bezug auf die Manipulationssicherheit weiter verbessert ist, sind Einrichtungen zur Lösung der Verbindung des Adapters mit der Zählertragplatte der Trägerplattform durch den an den Adapter angekoppelten Stromzähler blockiert.

Der durch plombierbare Einrichtungen in der Ankopplungsposition arretierte Stromzähler verhindert die Betätigung der betreffenden Einrichtungen, so dass der Adapter von der Zählertragplatte nicht lösbar ist und Manipulationen durch Unbefugte an der Stromzählereinrichtung ausgeschlossen sind.

Bei den Einrichtungen zur Lösung der Verbindung von Adapter und Zählertragplatte kann es sich z.B. um einen Kopf eines Verbindungselements, z.B. einer Schraube oder eines Bolzens, handeln, welcher durch den angekoppelten Stromzähler abgedeckt und dadurch unzugänglich ist.

Vorzugsweise sind zur Verbindung des Adapters mit der Zählertragplatte Hakenelemente auf der der Zählertragplatte zugewandten Seite des Adapters gebildet, wobei wenigstens eines der Hakenelemente im Schlitz einer Halteschiene eines Zählerkreuzes einhakbar sein kann.

Insbesondere ist wenigstens eines der Hakenelemente im Zuge einer Kippbewegung des Adapters in ein, vorzugsweise durch eine der Halteschienen des Zählerkreuzes gebildetes, Hakenwiderlager einhängbar. Vorzugsweise ist das betreffende Hakenelement am Rand einer der Zählertragplatte zugewandten Seitenfläche des Adapters angeordnet und weist einen sich parallel zu der Fläche zu dem Rand hin erstreckenden Hakenschenkel auf. Vorzugsweise steht dieser Hakenschenkel über den Rand hinaus vor. Die Kippbewegung erlaubt es, die Abmessungen des Hakenelements in bezug auf die Schlitzbreite so zu wählen, dass eine verbleibende Verschiebungsmöglichkeit parallel zur Zählertragplatte kleiner ist als die Länge des betreffenden Hokenschenkels, so dass der Adapter durch Parallelverschiebungen zur Zählertragplatte nicht in eine Stellung gelangen kann, in welcher er sich von der Tragplatte abheben lässt. Vorzugsweise sind zwei Hakenelemente im Schlitz der horizontalen Halteschiene des Zählerkreuzes eingehängt, während ein weiteres Hakenelement an einem den obengenannten Drehknopf aufweisenden Drehbolzen gebildet ist. Dieses Hakenelement greift in den Schlitz der vertikalen Halteschiene des Zählerkreuzes ein.

In weiterer Ausgestaltung der Erfindung weist der Adapter eine Anschlussleiste auf, und es ist eine Abdeckhaube, welche die Anschlussleiste und an die Anschlussleiste durch Öffnungen in der Zöhlertragplatte an die Anschlussleiste geführte Anschlussleitungen abdeckt, vorgesehen, wobei sich die Abdeckhaube formschlüssig zwischen dem Adapter und an dem an den Adapter gekoppelten Stromzähler oder sich der Stromzähler formschlüssig zwischen der Abdeckhaube und dem Adapter halten lässt. Allein durch die Arretierung und Plombierung des Stromzählers oder der Abdeckhaube sind damit beide Teile gesichert. Durch einen einzigen, wenigstens eines der beiden Teile gegen Verschiebung parallel zur Zählertragplatte sichernden Bolzen können beide Teile an Ort und Stelle gehalten werden.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: eine Adaptervorrichtung nach der Erfindung in einer perspektivischen An- sicht,
- Fig. 2: die Vorrichtung von Fig. 1 in einer teilweise geschnittenen Draufsicht,
- Fig. 3: eine Längsschnittansicht der Vorrichtung von Fig. 1,
- Fig. 4: eine Querschnittsansicht der Vorrichtung von Fig. 1,
- Fig. 5: einen Vertikalschnitt durch einen Zählerkasten, in welchen die Vorrichtung von Fig. 1 eingebaut ist,
- Fig. 6: einen Horizontalquerschnitt des Zählerkastens von Fig. 5,
- Fig. 7: ein zweites Ausführungsbeispiel für eine Adaptervorrichtung nach der Erfin- dung,
- Fig. 8: einen Stromzähleradapter nach der Erfindung in einer perspektivischen An- sicht,
- Fig. 9: den Stromzähleradapter von Fig. 1 in einer Rückansicht,
- Fig. 10: eine teilweise geschnittene Seitenansicht des Stromzähleradapters von Fig. 1, wobei der Adapter auf einer Zählertragplatte montiert ist,
- Fig. 11: eine die Befestigung des Zähleradapters von Fig. 1 an einer Zählertragplatte erläuternde Darstellung,
- Fig. 12: eine teilweise geschnittene Seitenansicht des Stromzähleradapters von Fig. 1 mit einer Leistenabdeckhaube, die sich am Adapter formschlüssig durch einen daran angekoppelten Stromzähler halten lässt,
- Fig. 13a und b: weitere Ausführungsformen von Stromzahleradapfern mit Leistenab- deckhauben, und
- Fig. 14: ein weiteres Ausführungsbeispiel für eine Hakenbefestigung.

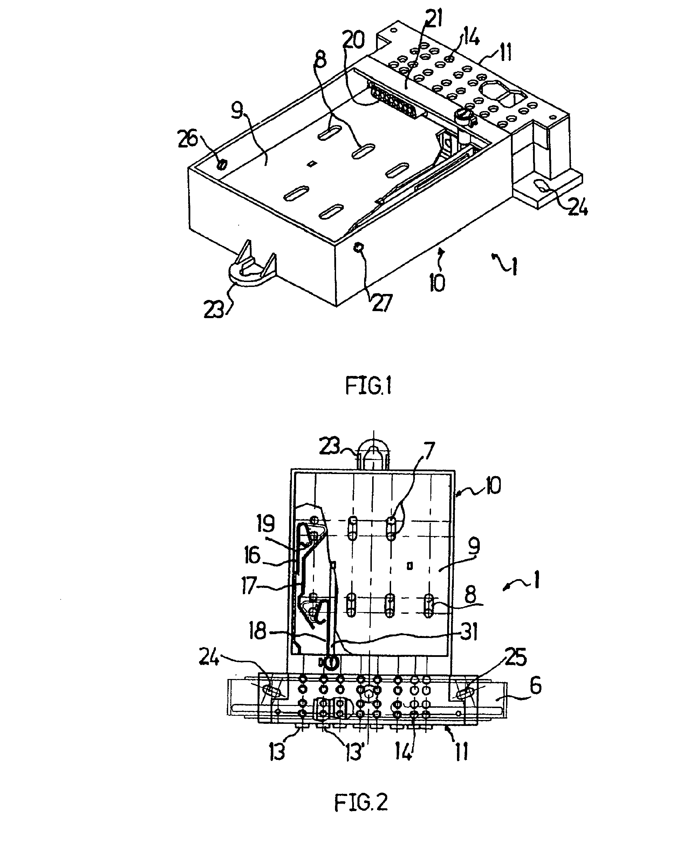

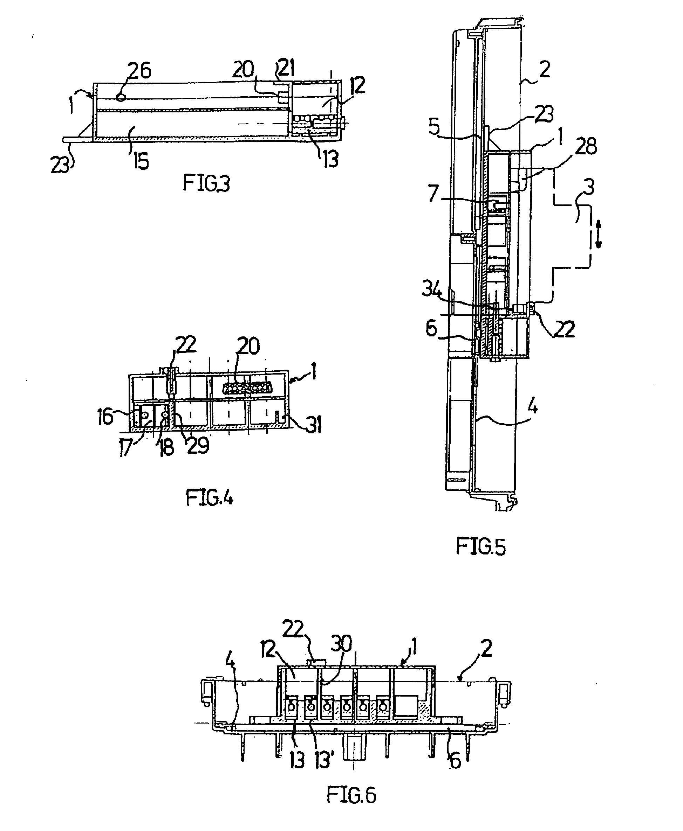

Ein in Fig. 1 bis 4 gezeigter Adapter 1 ist zum Einbau in einen Zählerkasten 2 (Fig. 5) vorgesehen. Über den Adapter 1 lässt sich in dem Zählerkasten 2 ein Stromzähler 3 installieren. In dem betreffenden Ausführungsbeispiel handelt es sich um einen elektronischen Stromzähler, dessen Gestaltung eine unmittelbare Verbindung mit dem Zählerkasten 2 nicht zulässt.

Wie Fig. 5 erkennen lässt, weist der elektronische Stromzähler 3 in Richtung zum Boden 4 des Zählerkastens vorstehende Kontaktstifte 7 auf. In dem betreffenden Ausführungsbeispiel sind sieben Kontaktstifte entsprechend drei Stromphasen und einem dem elektronischen Stromzähler 3 zuzuführenden Nullleiter vorgesehen. Die Kontaktstifte 7 greifen in Langlöcher 8 ein, welche in einem Zwischenboden 9 eines kastenartigen Teils 10 des Adapters 1 gebildet sind.

An einer Schmalseite des einseitig offenen Kastenteils 10 ist eine Anschlussleiste 11 angebracht.

In elektrisch gegeneinander durch Trennwände 30 isolierten Kammern 12 der Anschlussleiste 11 sind jeweils Schraubklemmanschlusselemente 13 und 13' entsprechend einem zum Stromzähler führenden und vom Stromzähler wegführenden Stromleiter gebildet. Die Schrauben der Schraubklemmanschlusselemente 13,13' sind durch Wandöffnungen 14 in der Anschlussleiste 11 für einen Schraubendreher zugänglich.

Unter dem Zwischenboden 9 des Kastenteils 10 befinden sich durch Zwischenwände 29 getrennte Kammern 15. Wie insbesondere aus Fig. 2 hervorgeht, sind in jeder Kammer 15 Federkontaktelemente 16 und 18 sowie ein Überbrückungsleiter 17 untergebracht, wobei für jede der drei Stromphasen ein solcher, durch gebogene Blechstreifen gebildeter Satz aus Federkontaktelementen und einem Überbrückungsleiter vorgesehen ist.

Die Federkontakfielemente 16 und 18 sind jeweils mit einem der Schraubklemmanschlusselemente 13 bzw. 13' verbunden. Solange der elektronische Zähler 3 nicht an den Adapter 1 gekoppelt ist, stehen die Federkontaktelemente 16 und 18 jeweils über eine elastisch abbiegbare Kontaktnase 19 in elektrischer Verbindung mit dem Überbrückungsleiter 17, d.h. die Schraubklemmanschlusselemente 13,13' sind kurzgeschlossen.

Das Bezugszeichen 20 bezeichnet ein Steckverbindungselement, über welches sich der Stromzähler 3, der ein entsprechendes Gegenstück aufweist (nicht gezeigt), mit Signalkabeln verbinden lässt. Das Steckanschlusselement 20 ist unterhalb eines sich im Abstand vom Zwischenboden 9 über dem Zwischenboden erstreckenden Wandteils 21 gebildet, welcher eine Öffnung für ein Steckschloss 22 aufweist. Durch den Wandteil 21 ist eine Tasche für die Aufnahme eines vorspringenden Abschnitts 34 des Zählergehäuses gebildet. Der Abschnitt 34 weist einen das Steckschloss 22 aufnehmenden Kanal auf.

An der der Anschlussleiste 11 gegenüberliegenden Seite des Adapters 1 ist eine Anschlusslasche z.B. zur Schraubbefestigung des Adapters am Schenkel 5 des Zählerkreuzes vorgesehen. Laschen 24 und 25 zur Schraubbefestigung am Schenkel 6 des Zählerkreuzes sind an den Längsenden der Anschlussleiste 11 gebildet.

Innerhalb des Kastenteils 10 sind an den Längswänden einander gegenüberliegend Nasen 26 und 27 für den Eingriff in Nuten 28 am Gehäuse des elektronischen Stromzählers 3 (Fig. 5) vorgesehen. Die Nuten 28 weisen zueinander im Winkel von 90° stehende Abschnitte auf.

Der Adapter 1 lässt sich auf dem Boden 4 des Zählerkastens 2, der eine Aufnahmeplattform für einen mittels Zählerkreuz zu befestigenden Stromzähler bildet, mit Hilfe der Schenkel 5 und 6 des Zählerkreuzes befestigen und über die Klemmanschlusselemente 13,13' mit in den Zählerkasten geführten Stromkabeln verbinden, die ihrerseits an einer im Zählerkasten 2 angebrachten Anschlussleiste (nicht gezeigt) enden können. Der Zählerkasten 2 mit dem darin eingebauten Adapter 1 ist damit in der Lage, den elektronischen Zähler 3 aufzunehmen.

Zur Ankopplung wird der elektronische Zähler 3 auf den Zwischenboden 9 aufgesetzt, wobei die von der Bodenfläche des Stromzählers 3 vorstehenden Kontaktstifte 7 durch die Langlöcher 8 hindurch in die Kammern 15 unter dem Zwischenboden 9 eingeführt werden. In der Position, in welcher der Stromzähler 3 auf den Zwischenboden 9 aufsetzbar ist, haben die Kontaktstifte noch keinen Kontakt zu den Federkontaktelementen 16 und 18 in den Kammern 15.

Der elektronische Stromzähler 3 lässt sich parallel zu dem Zwischenboden 9 verschieben, wobei der vorstehende Abschnitt 34 des Stromzählergehäuses in die Tasche unter den Wandteil 21 des Kastenteils 10 gelangt. Das am Zählergehäuse vorgesehene Steckverbindungsgegenstück greift dabei in das Steckverbindungselement 20 ein. Die Nasen 26 und 27 verschieben sich in einem Teil der Nuten 28 am Zählergehäuse, welcher sich parallel zum Zwischenboden 9 erstreckt. Der Stromzähler 3 ist damit formschlüssig an dem Zwischenboden gehalten.

Mit der Verschiebung des Stromzählers 3 kommen die Kontaktstifte 7 in Berührung mit den Kontaktnasen 19 der Federkontaktelemente 16 und 18. Bei weiterer Verschiebung werden, wie in Fig. 2 erkennbar ist, die Kontaktnasen 19 abgebogen, wobei sie zunächst in Kontakt mit dem Überbrückungsleiter 17 bleiben. In einer Anfangsphase der Ankopplung steht der Zähler 3 also in Kontakt mit den Stromleitern, während weiterhin eine Überbrückung durch das Kontaktelement 17 gegeben ist. Diese Phase kann der Funktionskontrolle des Stromzählers dienen, in welcher er unter (geringer) Spannung steht, der Strom durch den Überbrückungsleiter 17 aber noch fließt. So kann der Stromfluss nicht durch einen defekten Stromzähler unterbrochen werden.

In der Endstellung der Verschiebung sind die Kontaktnasen 19 von dem Überbrückungsleiter 17 abgehoben. Strom fließt nun nur noch über den Stromzähler 3.

In dieser Endstellung kann der Stromzähler 3 durch das Steckschloss 22, dessen Öffnung allein dem Stromversorgungsbetrieb vorbehalten ist, gegen Rückverschiebung gesichert werden. Zusätzlich könnte noch eine Plombierung erfolgen.

Mit Hilfe über das Steckverbindungselement 20 zugeführter Signalleitungen können z.B. Ferneinstellungen oder/und -auslesungen des Zählers 3 durch den Stromversorgungsbetrieb erfolgen.

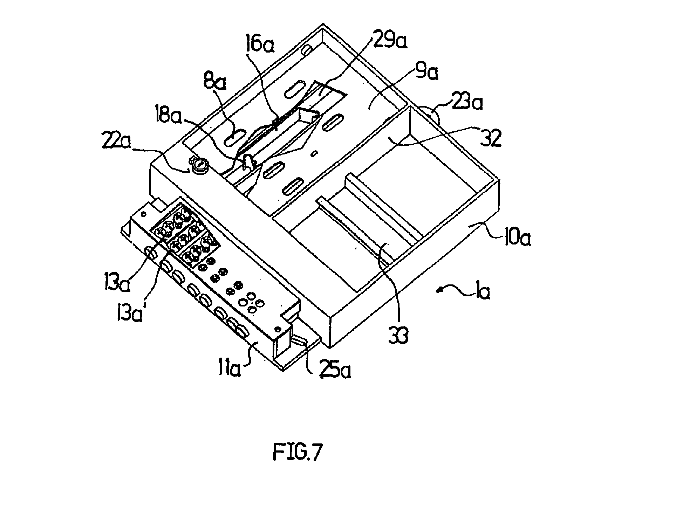

Es wird nun auf das Ausführungsbeispiel von Fig. 7 Bezug genommen, wo gleiche oder gleichwirkende Teile mit derselben Bezugszahl wie in den vorangehenden Figuren bezeichnet sind, wobei der betreffenden Bezugszahl jeweils der Buchstabe a beigefügt ist.

Das Ausführungsbeispiel von Fig. 7 unterscheidet sich von dem vorangehenden Ausführungsbeispiel dadurch, dass ein nach einer Seite erweiterter Kastenteil 10a vorgesehen ist, wobei in der durch eine Trennwand 32 abgetrennten Erweiterung eine Hutschiene 33 für die Aufnahme von Geräten, z.B. Steuergeräten, die mit dem elektronischen Stromzähler zusammenarbeiten, vorgesehen ist. Eine Abdeckung für die Erweiterung ist nicht gezeigt.

In dem gezeigten Ausführungsbeispiel verteilen sich Schraubklemmanschlusselemente 13a und 13a' im wesentlichen über die gesamte Länge einer mit dem Kastenteil 10a verbundenen Anschlussleiste 11 a. Entsprechend sind Federkontaktelemente 16a und 18a mit unterschiedlich langen Abwinklungen (nicht gezeigt) an ihren der Anschlussleiste 11 a zugewandten Enden erforderlich, um eine Verbindung zu den Schraubklemmanschlusselementen 13a,13a' herstellen zu können. Im übrigen können die Schraubklemmanschlusselemente zueinander in einem Normabstand angeordnet sein.

Abweichend von dem gezeigten Ausführungsbeispiel könnten Schraubklemmanschlusselemente auch nur über diejenige Länge der Anschlussleiste 11 a verteilt sein, welche der Breite des Stromzählers entspricht.

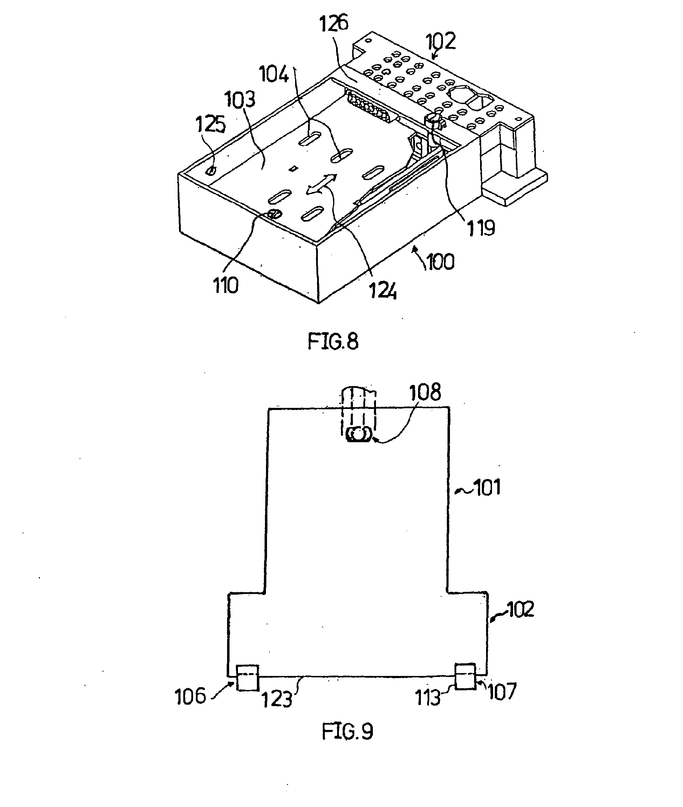

Im folgenden wird auf die Figuren 8 bis 14 Bezug genommen.

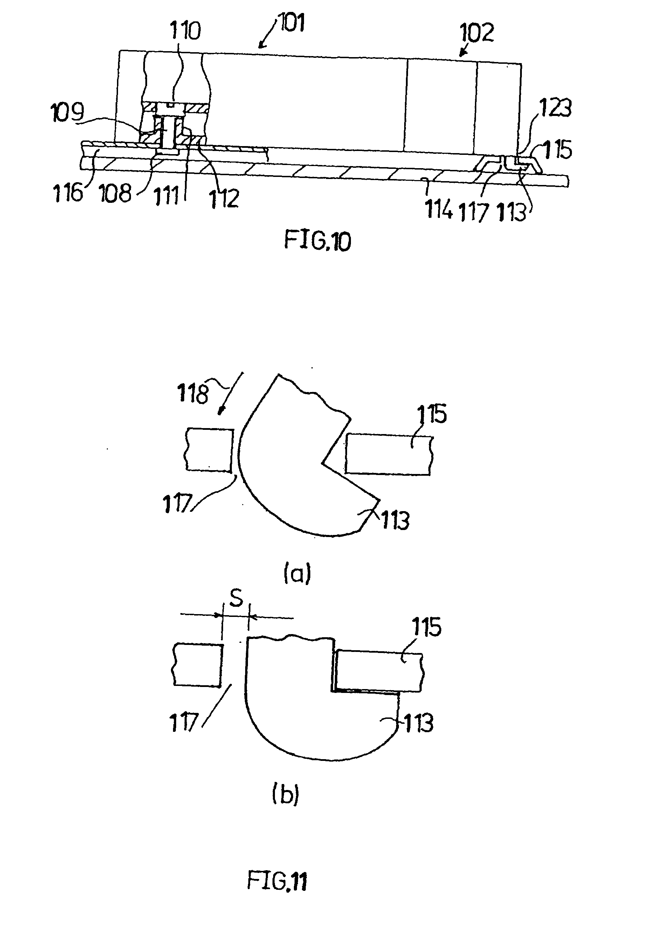

Ein dem Adapter von Fig. 1 ähnlicher Stromzähleradapter 100 mit einem Kunststoffgehäuse weist einen Kastenteil 101 und einen Klemmleistenteil 102 für den Anschluss von Stromleitern auf. Der Kastenteil 101 ist mit einem Zwischenboden 103 für die Aufnahme eines Stromzählers 105 gemäß Pfeil 130 (Fig. 10) versehen, wobei in dem Zwischenboden Öffnungen 104 für den Durchtritt von der Bodenfläche des Stromzählergehäuses vorstehender Kontaktelemente 121 gebildet sind. Unter dem Zwischenboden befinden sich Einrichtungen zum Anschluss der Kontaktelemente mit Leitern, welche zu dem Klemmleistenteil 102 geführt sind. Der Stromzähler 105 lässt sich auf dem Zwischenboden 103 gemäß Pfeil 124 hin- und herschieben, wobei er in einer durch einen Bolzen bei 119 arretierbaren Verschiebungsposition durch Zapfen 125 und einen Steg 126 formschlüssig am Zwischenboden 103 gehalten ist.

Auf seiner dem Stromzähler 105 abgewandten Seite weist der Stromzähleradapter Hakenelemente 106 bis 108 auf, wovon die Hakenelemente 106 und 107 einstückig an das Adaptergehäuse und das hammerartig ausgebildete Hakenelement 108 an einen Drehbolzen 109 angeformt sind. Ein mit einem Eingriffsschlitz für einen Schraubendreher versehener Kopf 110 des Drehbolzens 109 lässt sich gegen eine einstückig an das Gehäuse angeformte Hülse 111 anlegen, die sich in das Gehäuse hinein nach innen von einer Bodenwand 112 erstreckt. Abweichend hiervon ließe sich das Adaptergehäuse ohne Bodenwand ausbilden und am Zwischenboden ein Ansatz mit einer Einsenkung für die Aufnahme des Bolzenkopfes versehen.

Wie aus den Fig. 9 und 10 hervorgeht, sind die Hakenelemente 106 und 107 nahe einer Randkante 123 des Adaptergehäuse angeordnet, wobei ein zur Bodenwand 112 paralleler Hakenschenkel 113 jeweils über die Randkante hinaus vorsteht. Der Hakenschenkel könnte auch zur Randkante bündig sein oder zurückstehen. Zweckmäßig wird dann die Randkante abgeschrägt.

Zur Befestigung des Adapters an einer in einem Zählerschrank oder-kasten vorgesehenen Trägerplattform bzw. Zählertragplatte 114 (Fig. 10), werden die Hakenelemente 106 und 107 in einen Schlitz 117 einer Halteschiene 115 eingehängt. Bei der Halteschiene 115 handelt es sich um die horizontale Halteschiene eines Zählerkreuzes, das eine weitere, vertikal angeordnete Halteschiene 116 mit einem entsprechenden Schlitz aufweist.

Wie aus Fig. 11 a hervorgeht, erfolgt das Einhängen im Zuge einer Kippbewegung, bei welcher der Adapter gemäß Pfeil 118 in Richtung zu der Zählertragplatte 114 verschwenkt wird. Diese Art der Einhängung erlaubt es, die Hakenelemente 106, 107 im Verhältnis zur Breite des Schlitzes 117 so zu bemessen, dass der nach Einhängung mögliche, möglichst kleine Verschiebungsweg S parallel zur Zählertragplatte 114 kleiner als die Länge des Hakenschenkels 113 ist, so dass sich die Hakenelemente 106, 107 durch entsprechende Verschiebung des Adapters nicht aus der Verhakung lösen lassen.

Bei Drehung des Bolzens 109 hintergreift das Hakenelement 108 die vertikale Halteschiene 116 auf beiden Seiten ihres Schlitzes und verhindert eine die Elemente 106 und 107 aus ihrer Verhakung lösende Kippbewegung des Adapters.

Der auf den Zwischenboden 109 aufgesetzte und am Adapter durch einen verplombten Bolzen gegen Verschiebung parallel zum Zwischenboden gesicherte Stromzähler 105 versperrt den Zugang zum Drehbolzen 109, so dass sich die Befestigung des Adapters an der Zählertragplatte 114 unbefugterweise nicht lösen lässt.

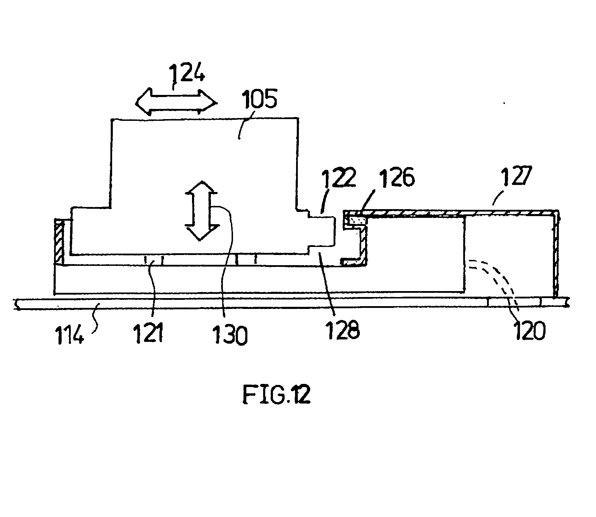

Es wird nun auf Fig. 12 Bezug genommen, wo mit der Bezugszahl 127 eine Leistenabdeckhaube bezeichnet ist, welche neben dem Klemmleistenteil 102 an den Klemmleistenteil 102 angeschlossene, durch eine Öffnung 120 in der Zählertragplatte 114 verlegte Anschlussleitungen abdeckt.

Der gemäß Pfeil 124 in seine Ankopplungsstellung verschobene Stromzähler 105 hält die Leistenabdeckhaube 127 formschlüssig zwischen sich und dem Adapter fest, wobei die Abdeckhaube 127 um den Steg 126 herumgeführt ist und in Stufenausnehmungen 122 und 128 am Zählergehäuse eingreift. Es wäre denkbar, die Abdeckhaube an ihrem dem Stromzähler 105 abgewandten Ende an der Zählertragplatte zu befestigen, etwa durch eine in einen Schlitz in der Zählertragplatte angreifendes Hakenelement.

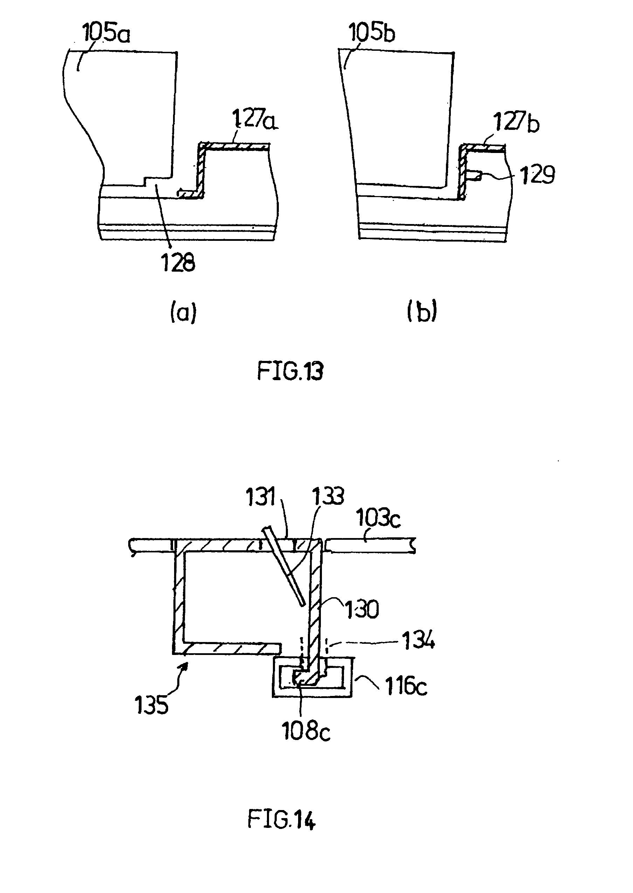

Fig. 13 zeigt weitere Ausführungsbeispiele für die formschlüssige Halterung einer Leistenabdeckhaube. Bei dem Ausführungsbeispiel von Fig. 13a fehlt der Steg 126. Entsprechend ist eine Abdeckhaube 127a nur zweimal abgewinkelt und ein Gehäuse eines Zählers 105a weist nur eine einzige Ausnehmung 128a auf.

Bei dem Ausführungsbeispiel von Fig. 13b ist eine Abdeckhaube 127b nur einfach abgewinkelt und mit einem in das Adaptergehäuse eingeführten Haltestift 129 versehen.

Umgekehrt könnte die Abdeckhaube den Stromzähler formschlüssig halten und Abdeckhaube und Stromzähler durch einen einzigen Bolzen gegen Verschiebung parallel zur Zählertragplatte gesichert sein.

Fig. 14 zeigt ein anstelle des Drehbolzens 109 verwendbares rahmenartiges Verbindungselement 135, das in einem Zwischenboden 103b versenkbar ist und einen elastischen Schenkel 130 mit einem Hakenelement 108c aufweist, das in eine Zählerkreuzhalteschiene 116c einrastbar ist. Durch eine Öffnung 131 in einem der Rahmenschenkel hindurch lässt sich durch ein Werkzeug 133 führen und die Verhakungsverbindung mit der Schiene lösen. Zur Vermeidung einer Hin- und Herbeweglichkeit gemäß Pfeil 132 kann in die Halteschiene 116c ein, z.B. mit dem Adaptergehäuse verbundener Bolzen 134 eingreifen, dessen Breite gleich der Schlitzbreite des Schlitzes in der Halteschiene 116c ist.

## Patentansprüche

1. Vorrichtung zur Ankopplung eines Stromzählers (3) an eine Trägerplattform (2) mit einem an der Trägerplattform anbringbaren Adapter (1), an welchen der Stromzähler (3) unter Verbindung mit Stromleitern (16,18) koppelbar ist,
**dadurch gekennzeichnet,**
**dass** der Adapter auf einer der Trägerplattform zugewandten Seite Hakenelemente (106-108) zur Verbindung des Adapters mit der Trägerplattform aufweist.

2. Vorrichtung nach Anspruch 1,
**dadurch gekennzeichnet,**
**dass** sich der Stromzähler (3) an dem Adapter (1) unter automatischer Verbindung ohne Werkzeugeinsatz über eine Schnellkupplung, vorzugsweise durch Formschluss, befestigen lässt.

3. Vorrichtung nach Anspruch 1 oder 2,
**dadurch gekennzeichnet,**
**dass** der Adapter (1) an der Trägerplattform (2) mittels Zählerkreuz (5,6) anbringbar ist.

4. Vorrichtung nach einem der Ansprüche 1 bis 3,
**dadurch gekennzeichnet,**
**dass** der Adapter (1) einen einseitig offenen Kasten (10) mit einem den Stromzähler (3) aufnehmenden Zwischenboden (9) aufweist.

5. Vorrichtung nach einem der Ansprüche 1 bis 4,
**dadurch gekennzeichnet,**
**dass** der Adapter Einrichtungen (33) zur Anbringung zusätzlicher Geräte aufweist.

6. Vorrichtung nach einem der Ansprüche 1 bis 5
**dadurch gekennzeichnet,**
**dass** Einrichtungen (109,110) zur Lösung der Verbindung des Adapters mit einer Zöhlertragplatte (114) der Trägerplattform durch den an den Adapter angekoppelten Stromzähler (105) blockiert sind.

7. Stromzähleradapter nach einem der Ansprüche 1 bis 6,
**dadurch gekennzeichnet,**
**dass** wenigstens eines der Hakenelemente (106-108) im Schlitz einer der Halteschienen des Zählerkreuzes (115, 116) einhakbar ist.

8. Stromzähleradapter nach Anspruch 7
**dadurch gekennzeichnet,**
**dass** wenigstens eines (106, 107) der Hakenelemente (106-108) im Zuge einer Kippbewegung des Adapters in ein, vorzugsweise durch eine der Halteschienen des Zählerkreuzes (115, 116) gebildetes, Hakenwiderlager einhängbar ist.

9. Stromzähleradapter nach Anspruch 8,
**dadurch gekennzeichnet,**
**dass** das wenigstens eine Hakenelement (106, 107) am Rand einer der Zählertragplatte (114) zugewandten Fläche des Adapters angeordnet ist, wobei ein zu der Fläche paralleler Hakenschenkel (113) des Hakenelements (106, 107) zu dem Rand hin gerichtet ist.

10. Stromzähleradapter nach Anspruch 9,
**dadurch gekennzeichnet,**
**dass** der Hakenschenkel (113) über den Rand hinaus vorsteht.

11. Stromzähleradapter nach einem der Ansprüche 1 bis 10,
**dadurch gekennzeichnet,**
**dass** wenigstens eines (108) der Hakenelemente (106-108) an einem den Drehkopf (110) aufweisenden Drehbolzen (109) gebildet ist.

12. Stromzähleradapter nach Anspruch 11
**dadurch gekennzeichnet,**
**dass** das wenigstens eine Hakenelement (108) im Schlitz der vertikalen Halteschiene (116) des Zählerkreuzes (115, 116) einhakbar ist.

13. Stromzähleradapter nach einem der Ansprüche 1 bis 12,
**dadurch gekennzeichnet,**
**dass** der Adapter eine Anschlussleiste (102) aufweist, und eine Abdeckhaube (119), welche die Anschlussleiste (102) und an die Anschlussleiste (102) durch Öffnungen (120) in der Zählertragplatte (114) an die Anschlussleiste (102) geführte Leitungen abdeckt, vorgesehen ist, wobei sich die Abdeckhaube (119) formschlüssig zwischen dem Adapter und dem an den Adapter gekoppelten Stromzähler (105) oder sich der Stromzähler (105) formschlüssig zwischen der Abdeckhaube (119) und dem Adapter festhalten lässt.

14. Stromzähleradapter nach Anspruch 13,
**dadurch gekennzeichnet,**
**dass** ein in einem den Stromzähler aufnehmenden Zwischenboden (1 03b) versenkbares Verbindungselement (135) vorgesehen ist, das einen elastischen Hakenschenkel (130) aufweist und im Zwischenboden eine Öffnung (132) für die Durchführung eines die Verhakung lösenden Werkzeugs (133) gebildet ist.

15. Stromzähleradapter nach Anspruch 14
**dadurch gekennzeichnet,**
**dass** zusätzlich zu dem Hakenschenkel (130) in eine hinterschnittene Verhakungsrille ein Bolzen (134) eingreift, dessen Durchmesser gleich der Breite der Verhakungsrille ist.
